# EUROPEAN PATENT SPECIFICATION

(11) **EP 2 326 007 B1**
(45) Date of publication and mention of the grant of the patent: **09.01.2013**
(21) Application number: 09176540.4
(22) Date of filing: 19.11.2009
(51) Int. Cl.: H03K 17/10, H03K 19/007

(54) **Circuit and topology for very high reliability power electronics system**
Schaltung und Topologie für ein äußerst zuverlässiges Leistungselektroniksystem
Circuit et topologie pour système électronique de puissance très fiable

(43) Date of publication of application: 25.05.2011
(73) Proprietor: General Electric Company, Schenectady, NY 12345 (US)
(72) Inventor: Sihler, Christof Martin, 85399 Hallbergnoos (DE); Roesner, Robert, 80797 Munich (DE)
(74) Representative: Illingworth-Law, William Illingworth

(56) References cited:
- EP-A1- 2 071 694
- EP-A2- 0 478 289
- WO-A2-2008/113337
- FR-A1- 2 524 674
- JP-A- 2 055 571

## Description

### BACKGROUND

The invention relates generally to power electronics, and more specifically to a circuit and system topology to provide a high reliability power system.

Document EP 2 071 694 A1 discloses a power electronics system comprising a plurality of substantially identical semiconductor switching devices connected in series to provide a high reliability switch.

FR 2 524 674 discloses a device for detecting anomalies. A plurality of detectors, each located at an observation site, sends a signal to a logic gate.

Power electronic systems in the megawatt range generally consist of a large number of power and control components. Redundancy concepts, other than ruggedizing the components, have typically been employed to improve the reliability of these power electronic systems. One of the most prevalent examples of redundant topologies is the series connection of n+1 or more components such as thyristors. This series connection technique typically limits the redundancy to power semiconductors, as the control system itself, and especially the interface between the controls and the power semiconductor(s) is not redundant.

The risk of non-redundant interface failure(s) between the control system and the power semiconductors, although acceptable for standard industrial applications, is not acceptable for sub-sea power conversion systems. This is because the demands in terms of reliability for sub-sea power conversion systems such as oil and/or gas industry sub-sea installations are much higher. Necessary interventions in case of failure are much more demanding in terms of time and cost for sub-sea power conversion systems.

Redundancies in sub-sea power converters, for example, are a must have since the use of spare parts commonly employed in other applications is not economical. In such sub-sea applications, spare units that are to be installed after years of storage must be tested under operating conditions closely matching the sub-sea operating conditions.

One option to improve system reliability would be to install an additional power electronic unit. The costs associated with sub-sea power electronics typically does not represent more than about 20% of the total cost of a sub-sea power conversion unit. Passive components require most of the space of a sub-sea power conversion unit. A failure of these passive components is very unlikely when properly designed. Therefore, it may be attractive to install a spare power electronics and control unit in each marinized sub-sea conversion unit. The spare unit would not contribute to operation losses, could be tested from time to time, and could take over the controlled supply of the load without relevant system interruption time.

In case afore mentioned in not viable solution, another option would be to design a system with no single point of failure. It would be both advantageous and beneficial in view of the foregoing, to provide a circuit/system for eliminating any single point of failure associated with a power converter/power electronics system, and that can be employed with almost any known power electronics topologies. It would be further advantageous if the circuit/system could fit easily within existing AC/DC converter topologies, DC/AC converter topologies, or DC/DC converter topologies.

### BRIEF DESCRIPTION

The present invention provides a power electronics system as defined in claim 1.

Briefly, in accordance with the invention, a power electronics system comprises:
a plurality of substantially identical semiconductor switching devices connected in series to provide a high reliability switch, each semiconductor switching device being driven via a corresponding gate drive unit having a voting unit integrated therein; and
a plurality of substantially identical controller units, wherein each voting unit signal is configured to provide a corresponding semiconductor switching device drive signal in response to output signals from a plurality of controller units, the output signal of each of the plurality of controller units is applied to each of the voting and gate drive units and each output signal is in communication with each respective integrated voting and gate drive unit such that the corresponding semiconductor switching device is controlled via a voting result of the plurality of controller units regardless of whether a failure occurs in any one or more of the controller units so long as at least a minimum number of controller units remains operational.

### DRAWINGS

These and other features, aspects, and advantages of the present invention will become better understood when the following detailed description is read with reference to the accompanying drawings in which like characters represent like parts throughout the drawings, wherein:

Figure 1 illustrates a circuit and system topology for a high power electronics system, according to one embodiment of the invention.

Figure 2 illustrates an example implementation of a standard 2-level phase leg with no single point of failure;

Figure 3 illustrates a circuit and system topology for a high power electronics system;

Figure 4 illustrates one example embodiment of a DC/DC converter depicting series connected devices; and

Figure 5 is a simplified representation of a DC/AC inverter system driving individual subsea loads.

While the above-identified drawing figures set forth particular embodiments, other embodiments of the present invention are also contemplated, as noted in the discussion. In all cases, this disclosure presents illustrated embodiments of the present invention by way of representation and not limitation. Numerous other modifications and embodiments can be devised by those skilled in the art.

### DETAILED DESCRIPTION

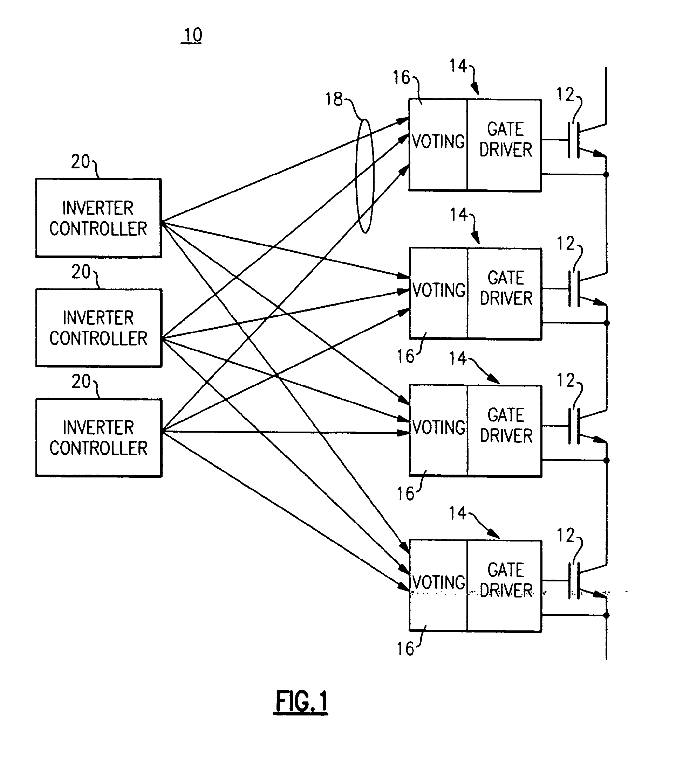

Figure 1 illustrates a circuit and system topology for a high power electronics system with no single point of failure which is used as a basic building block for many different embodiments. The high power electronics system 10 serves as a single switch function and may be employed in almost every known power electronics topology. It includes a plurality (n+1) of substantially identical high power switching devices 12 such as, without limitation, power semiconductors connected in a series configuration to provide a desired level of switch redundancy such that the switch will continue to function following a short circuit failure mode of one or more of the switching devices 12. The power semiconductors can be, without limitation, IGBT or IGCT or thyristor devices.

The high power electronics system 10 provides a desired level of reliability/availability by extending the foregoing redundancy features also to the entire system. While a standard gate drive unit has only a single input that is used to control its output state, the high power electronics system 10 gate drive units 14 each have a corresponding voting unit 16. Each voting unit 16 has a plurality of inputs 18. Each voting unit input 18 is driven by a corresponding control unit 20. Each control unit 20 is configured to provide inputs to additional voting units 16 in the unlikely event of one or more control unit failures. Each voting unit can employ, for example, XOR logic that is integrated with the switching device 12 gate drive unit 14.

Although only n=3 control units 20 are shown, other embodiments can just as easily be employed that utilize any desired number n of control units 20 and corresponding voting units 18 that are configured with the requisite number of inputs corresponding to a desired number n of control units 20.

The high power electronics system 10 therefore extends the redundancy features also to other portions of the system 10 beyond just the high power switching devices 12. The gate drive units 14 and the voting units 16 are made redundant via the corresponding power semiconductor 12; and redundant gate drive control units 20 are configured to provide redundant input signals to each voting unit 16.

According to one embodiment, a particular high power switching device 12 is turned on if any two or more voting inputs 18 are commanding an on-state for a corresponding voting unit 16. The circuit and system topology depicted in Figure 1 therefore eliminates any single point of failure including the switching devices 12 and all corresponding control 20 and drive units 14 and voting units 16.

The short circuit failure mode feature of the power device 12 is a passive redundancy concept since there is no requirement for any failure detection and/or isolation scheme. Any failed device remains in the circuit for the entire useful life of the system 10. According to one embodiment, the high power electronics system 10 is a marinized design for subsea applications.

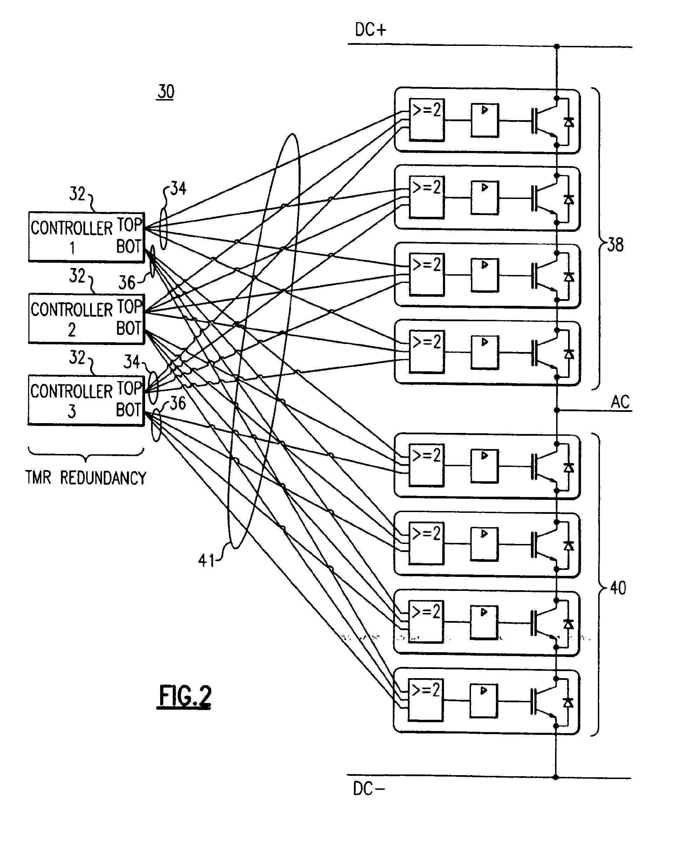

Figure 2 illustrates a circuit and system topology for a high power electronics system 30, according to another embodiment of the invention. The high power electronics system 30 employs a plurality of redundant front end controllers 32. Each front end controller 32 is configured with a plurality of output groups 34, 36. Output group 34 is configured to control one group of switching devices 38 including the corresponding voting and gate drive units. Output group 36 is configured to control another group of switching devices 40 including the corresponding voting and gate drive units, such as described above. The circuit and system topology depicted in Figure 2 therefore provides a desired level of device redundancy such that the high power electronics system 30 will continue to operate, regardless of whether a particular controller 32 fails, or whether a failure occurs within a particular group of switching devices 38, 40 or an interconnection 41 failure.

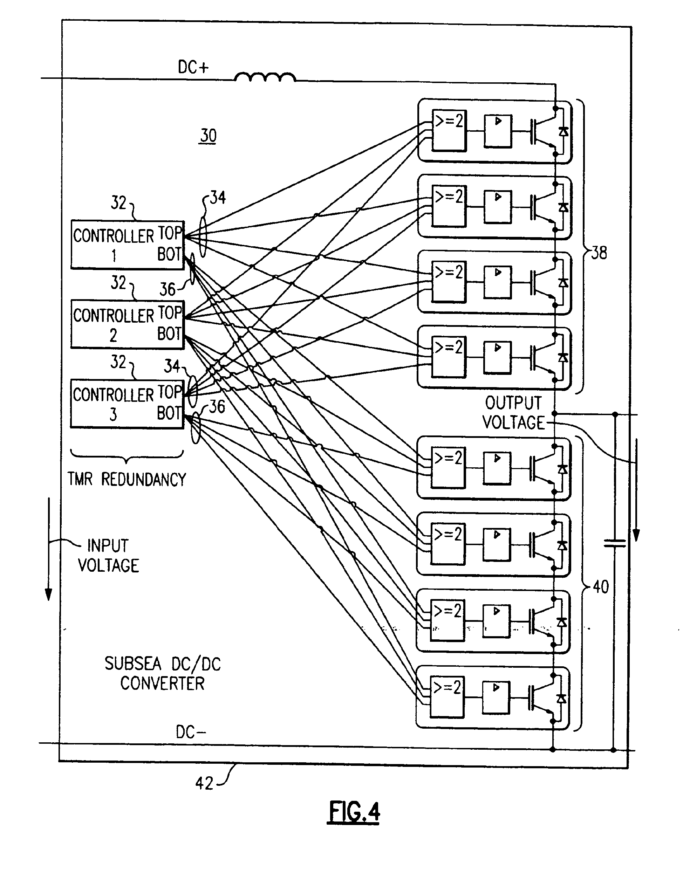

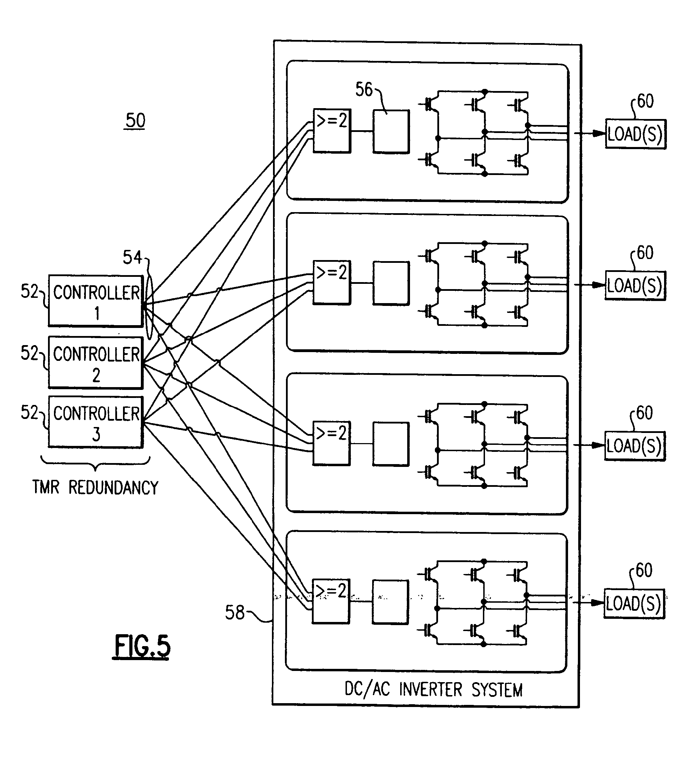

According to some embodiments, the high power electronics system 30 comprises groups of series connected devices 38, 40 in a subsea DC/DC converter 42 such as depicted in Figure 4, or one or a multiple of DC to AC inverter modules 58 supplying one or a multiple of loads 60 such as depicted in Figure 5.

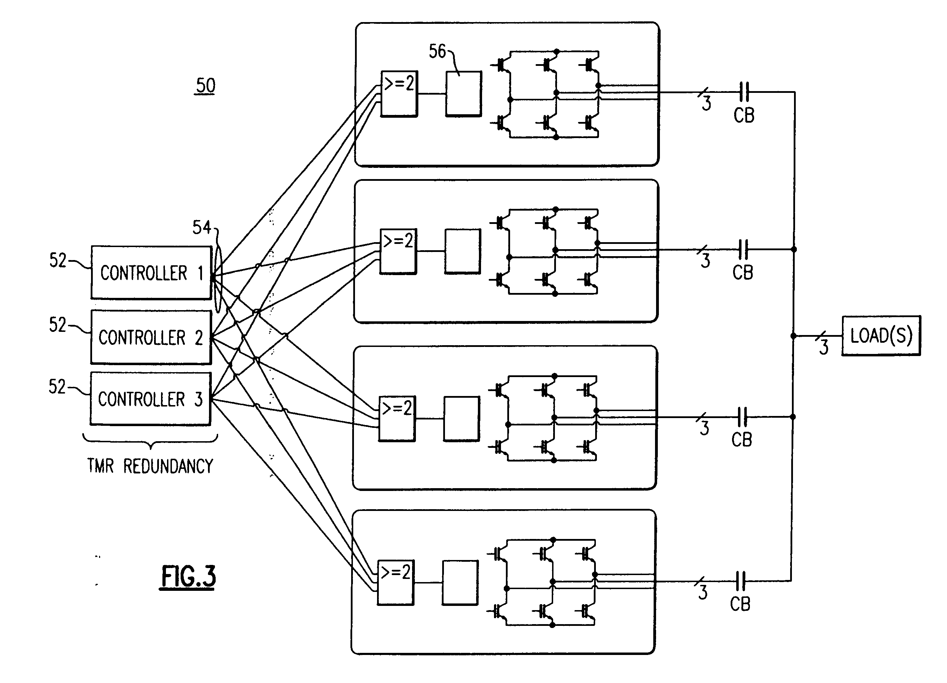

Figure 3 illustrates a circuit and system topology for a high power electronics system 50. The high power electronics system 50 employs a plurality of redundant front end controllers 52. Each front end controller 52 is configured with a plurality of outputs 54 in which each controller output 54 operates to supply a voting unit input signal, such as described above. Each front end controller is configured to provide all necessary signals to control one or multiple two or three phase DC/AC converter. The circuit and system topology depicted in Figure 3 therefore provides a desired level of device redundancy such that the high power electronics system 50 will continue to operate, regardless of whether a particular controller 52 fails, or whether a particular bridge circuit 56 fails. The circuit and system topology depicted in Figure 3 comprises an inverter system driving one or more subsea loads.

In summary explanation, a high reliability power electronics system has been described that provides a desired level of system and/or device redundancy in a simple and more compact manner than other known systems. The high reliability power electronics system is particularly useful to achieve a desired level of reliability for sub-sea applications in which reliability is a key factor and the cost of power electronics does not really matter since this cost is typically less than 5% of the total system cost.

Device level redundancy for the high reliability power electronics system can be achieved in a simple and more compact way than in other known applications because the gate signals of all series connected devices are identical. System redundancies in one embodiment relate only to active components since passive components are not as likely to fail, are too heavy, and consume excessive space.

A sub-sea application using the principles described herein may, for example, employ only active component redundancy allowing a system to be remotely configured subsequent to a fault and/or shutdown such that a restart is possible and operation can continue using different active but the same passive devices.

Although particular embodiments described above enable continued operation in the event of either a device or control unit failure, redundant topologies can also be configured using the principles described herein to enable continued operation of a complete subsystem such as a power converter, subsequent to a subsystem failure or shutdown. Such a topology may, for example, switch off the failed subsystem and enable operation of a redundant subsystem that employs a different set of active devices but continues to utilize the same set of passive devices, including without limitation, capacitors, inductors, transformers, and the like. Continued use of the existing passive devices will ensure that minimum size and weight constraints are maintained.

The embodiments described above are particularly useful to the elimination of the need to maintain spare unit testing requirements. Because spare units must be tested under operating conditions as close as possible to the sub-sea operating conditions, keeping additional spares requires a major effort, regardless of whether such spares are to be installed on a beach once a fault has occurred, or whether such spares are associated with a permanently installed test station, since the tests would require a representative onshore motor load connected to a generator with braking resistors.

While only certain features of the invention have been illustrated and described herein, many modifications and changes will occur to those skilled in the art.

## Claims

1. A power electronics system (10) comprising:
a plurality of substantially identical semiconductor switching devices (12) connected in series to provide a high reliability switch, each semiconductor switching device (12) being driven via a corresponding gate drive unit (14) having a voting unit (16) integrated therein; and
a plurality of substantially identical controller units (20), wherein each voting unit (16) is configured to provide a corresponding semiconductor switching device drive signal (18) in response to output signals from a plurality of controller units (20), the output signal of each of the plurality of controller units (20) is applied to each of the voting and gate drive units and each output signal is in communication with each respective integrated voting (16) and gate drive (14) unit such that the corresponding semiconductor switching device (12) is controlled via a voting result of the plurality of controller units (20) regardless of whether a failure occurs in any one or more of the controller units (20) so long as at least a minimum number of controller units (20) remains operational.

2. The power electronics system (10) according to claim 1, wherein the plurality of substantially identical semiconductor switching devices (12) are configured to function as a high reliability switch regardless of whether a short circuit failure occurs in any one or more of the switching devices (12) so long as at least a minimum number of switching devices remains operational.

3. The power electronics system (10) according to claim 1 or claim 2, wherein the plurality of substantially identical semiconductor switching devices (12), corresponding gate drive units (14) and respective integrated voting units (16), and the plurality of substantially identical controller units (20) are together configured as a sub-sea power electronics system.

4. The power electronics system (10) according to any one of the preceding claims, wherein the plurality of substantially identical semiconductor switching devices (12) are integrated within a subsea DC/DC converter (42) or one or more DC to AC inverter modules (58).

## Patentansprüche

1. Leistungselektroniksystem (10), aufweisend:
mehrere im Wesentlichen identische Halbleiterschaltelemente (12), die in Reihe geschaltet sind, um einen hoch zuverlässigen Schalter bereitzustellen, wobei jedes Halbleiterschaltelement (12) über eine entsprechende Gate-Steuereinheit (14) mit einer darin integrierten Abstimmungseinheit (16) angesteuert wird; und
mehrere im Wesentlichen identische Steuereinheiten (20), wobei jede Abstimmungseinheit (16) dafür eingerichtet ist, in Reaktion auf Ausgangssignale von mehreren Steuereinheiten (20) ein entsprechendes Halbleiterschaltelement-Steuersignal (18) zu erzeugen, wobei das Ausgangssignal von jeder von den mehreren Steuereinheiten (20) an jede von den Abstimmungs- und Gate-Treibereinheiten angelegt wird und wobei jedes Ausgangssignal mit jeder entsprechenden integrierten Abstimmungs- (16) und Gate-Steuereinheit (14) so in Verbindung steht, dass das entsprechende Halbleiterschaltelement (12) über ein Abstimmungsergebnis der mehreren Steuereinheiten (20) unabhängig davon gesteuert wird, ob ein Fehler in einer oder mehreren von den Steuereinheiten (20) auftritt, solange wenigstens eine minimale Anzahl von Steuereinheiten (20) betriebsfähig bleibt.

2. Leistungselektroniksystem (10) nach Anspruch 1, wobei die mehreren im Wesentlichen identischen Halbleiterschaltelemente (12) dafür eingerichtet sind, als ein hoch zuverlässiger Schalter unabhängig davon zu funktionieren, ob ein Kurzschlussfehler in irgendeinem oder mehreren von den Schaltelementen (12) auftritt, solange wenigstens eine minimale Anzahl von Schaltelementen betriebsfähig bleibt.

3. Leistungselektroniksystem (10) nach Anspruch 1 oder Anspruch 2, wobei die mehreren im Wesentlichen identischen Halbleiterschaltelemente (12), entsprechende Gate-Treibereinheiten (14) und entsprechende Abstimmungseinheiten (16) und die mehreren im Wesentlichen identischen Steuereinheiten (20) zusammen als ein Unterwasser-Leistungselektroniksystem ausgestaltet sind.

4. Leistungselektroniksystem (10) nach einem der vorstehenden Ansprüche, wobei die mehreren im Wesentlichen identischen Halbleiterschaltelemente (12) in einen Unterwasser-DC/DC-Wandler (42) oder in ein oder mehrere DC/AC-Umrichtermodule (58) integriert sind.

## Revendications

1. Système électronique de puissance (10) comportant :
une pluralité de dispositifs de commutation sensiblement identiques (12) à semi-conducteurs, montés en série pour réaliser un commutateur d'une grande fiabilité, chaque dispositif de commutation (12) à semi-conducteur étant commandé par l'intermédiaire d'une unité d'attaque de grille correspondante (14) dans laquelle est intégrée une unité de vote (16) ; et
une pluralité d'unités de commande sensiblement identiques (20), dans lesquelles chaque unité de vote (16) est conçue pour produire un signal de commande correspondant (18) de dispositif de commutation à semi-conducteur en réponse à des signaux de sortie d'une pluralité d'unités de commande (20), le signal de sortie de chacune des différences unités de commande (20) est appliqué à chacune des unités de vote et d'attaque de grille et chaque signal de sortie communique avec chaque unité respective de vote intégrée (16) et d'attaque de grille (14) de façon que le dispositif de commutation à semi-conducteur correspondant (12) soit commandé par l'intermédiaire d'un résultat de vote de la pluralité d'unités de commande (20) indépendamment de la survenance d'un dysfonctionnement dans l'une quelconque ou davantage des unités de commande (20) aussi longtemps qu'au moins un nombre minimal de dispositifs de commutation (20) restent en état de marche.

2. Système électronique de puissance (10) selon la revendication 1, dans lequel la pluralité de dispositifs de commutation sensiblement identiques (12) à semi-conducteurs sont conçus pour servir de commutateurs d'une grande fiabilité indépendamment de la survenance d'un incident tel qu'un court-circuit dans l'un quelconque ou davantage des dispositifs de commutation (12) aussi longtemps qu'au moins un nombre minimal de dispositifs de commutation restent en état de marche.

3. Système électronique de puissance (10) selon la revendication 1 ou la revendication 2, dans lequel la pluralité de dispositifs de commutation sensiblement identiques (12) à semi-conducteurs, les unités d'attaque de grilles correspondantes (14) et les unités de vote intégrées respectives (16), et la pluralité d'unités de commande sensiblement identiques (20) sont conçus conjointement en tant que système électronique de puissance sous-marin.

4. Système électronique de puissance (10) selon l'une quelconque des revendications précédentes, dans lequel la pluralité de dispositifs de commutation sensiblement identiques (12) à semi-conducteurs sont intégrés dans un convertisseur continu-continu sous-marin (42) ou dans un ou plusieurs modules d'inversion continu-alternatif (58).
